Europäisches Patentamt

European Patent Office

Office européen des brevets

(11) Numéro de publication: **0 484 853 A1**

# DEMANDE DE BREVET EUROPEEN

(21) Numéro de dépôt: **91118766.4**

(22) Date de dépôt: **04.11.91**

(51) Int. Cl.5: **H05K 9/00**

(30) Priorité: **07.11.90 FR 9013802**

(43) Date de publication de la demande:
**13.05.92 Bulletin 92/20**

(84) Etats contractants désignés:
**DE FR GB IT**

(71) Demandeur: **ALCATEL ESPACE**
**11, avenue Dubonnet**
**F-92407 Courbevoie Cédex(FR)**

(72) Inventeur: **Youssef, Abdul, c/o CNET-CRPE**
**38-40, rue du Général Leclerc**
**F-92131 Issy les Moulineaux(FR)**
Inventeur: **Ducrocq, Jean-Bernard**
**chemin Jaqui, Pechabou**
**F-31320 Castanet Tolosan(FR)**
Inventeur: **Meyer, Alain, c/o CNET-CRPE**
**38-40, rue du Général Leclerc**
**F-92131 Issy les Moulineaux(FR)**

(74) Mandataire: **Weinmiller, Jürgen et al**
**Lennéstrasse 9 Postfach 24**
**W-8133 Feldafing(DE)**

(54) **Méthode de protection de composants electroniques d'un circuit contre les radiations et dispositif utilisant cette méthode.**

(57) L'invention concerne une méthode de protection de composants électroniques (4, 5) d'un circuit contre les radiations, la protection étant obtenue par l'utilisation d'un matériau de blindage, caractérisée en ce qu'elle consiste à répartir le matériau de blindage en éléments (10, 11, 12) de manière à assurer une protection localisée des composants.

L'invention concerne également un dispositif de protection de composants électroniques mettant en oeuvre cette méthode.

FIG. 1

EP 0 484 853 A1

Rank Xerox (UK) Business Services
(-/2.18/2.0)

L'invention concerne une méthode de protection de composants électroniques d'un circuit contre les radiations. Elle concerne également les dispositifs utilisant cette méthode et s'applique notamment aux circuits électriques embarqués dans des engins spatiaux et plongés dans un environnement radiatif.

Lorqu'un équipement électronique est appelé à fonctionner dans un environnement radiatif, il est impératif de protéger les composants électroniques de cet équipement contre les effets de ces radiations. L'environnement radiatif peut se manifester sous forme corpusculaire et sous forme électromagnétique. Ces radiations dégradent les performances des composants électroniques et peuvent même les détruire.

Il est connu de protéger les composants électroniques en entourant les boîtiers qui les contiennent par un matériau dense, d'épaisseur suffisante pour arrêter les radiations. C'est une technique qui s'adapte mal aux nouvelles technologies de montage hybride utilisées en électronique dans lesquelles interviennent des macrocomposants encombrants. De plus, cette technique entraîne des difficultés pour le passage des connexions électriques au travers de l'enveloppe de protection. Enfin, une protection extérieure au boîtier nécessite une protection primaire pour limiter les effets secondaires dus au phénomènes de perte d'énergie par rayonnement de freinage (phénomène de bremsstrahlung). Cette technique de protection est, de ce fait, très pénalisante en poids et délicate à mettre en oeuvre.

La méthode consistant à envelopper un composant électronique par un blindage de protection ne concerne que les composants encapsulés ou conditionnés. Elle peut s'appliquer aux macrocomposants hydrides, mais elle entraîne alors un excès de poids et d'encombrement qui est préjudiciable. Cette méthode n'est pas encore optimisée et elle nécessite des opérations préalables d'assemblage et de conditionnement du composant à protéger. La mise en oeuvre de cette technique est délicate et coûteuse.

Une autre méthode, beaucoup plus simple que la précédente, consiste à blinder non plus le composant lui-même mais le circuit électronique par un boîtier métallique d'épaisseur suffisante pour lui assurer la protection exigée. L'inconvénient de cette méthode réside dans le poids excessif mis en jeu qui constitue un obstacle majeur dans les applications spatiales. En effet, dans ce domaine, les équipements électroniques sont plongés dans un environnement très hostile et sont soumis à des exigences draconiennes quant à la masse et à la consommation d'énergie électrique. Ces contraintes sont dominantes pour les équipements installés sur des bras, à l'extérieur des satellites.

Afin de pallier ces inconvénients, on propose selon la présente invention de protéger contre les radiations les composants électroniques d'un circuit électronique grâce à une protection individuelle, localisée et avantageusement située à l'intérieur du boîtier d'encapsulation du circuit. Les composants en puces nues ou en chips se prêtent particulièrement bien à ce mode de protection, laquelle est réalisée au moyen de matériaux denses en contact, ou pratiquement en contact avec le composant sensible à protéger. Le mode de montage des éléments de protection localisés peut être tel qu'il permette une continuité électrique avec le support du composant, et l'écoulement des charges électrostatiques engendrées par l'environnement.

L'invention a donc pour objet une méthode de protection de composants électroniques d'un circuit contre les radiations, la protection étant obtenue par l'utilisation d'un matériau de blindage, caractérisée en ce qu'elle consiste à répartir le matériau de blindage en éléments de manière à assurer une protection localisée des composants, la superficie de ces éléments étant telle qu'ils assurent la protection des composants pour un angle critique d'incidence des radiations estimé pour chaque composant.

L'invention a aussi pour objet un dispositif de protection des composants électroniques d'un circuit, le dispositif comportant un matériau de blindage destiné à la protection de ces composants, caractérisé en ce que le matériau de blindage est réparti en éléments assurant une protection localisée des composants.

L'invention sera mieux comprise et d'autres avantages apparaîtront à la lecture de la description qui va suivre, donnée à titre non limitatif, accompagnée des dessins annexés parmi lesquels :

- la figure 1 représente, vue en coupe transversale, un équipement électronique dans son boîtier et équipé de protections selon l'invention,
- la figure 2 est une vue de dessus de l'équipement électronique correspondant à la figure 1, sans son couvercle,
- la figure 3 représente un boîtier en coupe partielle et illustre le montage d'une puce nue montée en technologie hybride et équipée de protections selon l'invention.

La description va porter sur un circuit électronique hybride comprenant un seul substrat disposé dans un boîtier plat, par souci de simplification. Cependant, l'invention concerne également des boîtiers ayant une autre forme et qui peuvent contenir plusieurs substrats ou cartes supportant des circuits électroniques.

La protection localisée in situ, faite au niveau des composants et plus avantageusement au niveau des puces nues ou des chips, à l'intérieur du boîtier d'encapsulation du circuit hybride, réduit les poids et ne nécessite pas ou nécessite peu de protection primaire extérieure du fait de l'effet de freinage du boîtier lui-même.

Pour réaliser la protection in situ selon l'invention, il faut concevoir l'implantation des matériaux de protection sur ou au sein du support du circuit hybride, en fonction de sa compatibilité avec les méthodes de fabrication des circuits hybrides.

Il faut également tenir compte de la tenue de ces matériaux aux contraintes mécaniques environnantes (vibrations) et de l'écoulement des charges électrostatiques accumulées.

L'un des avantages de l'invention est de pouvoir réaliser la protection in situ des composants sensibles en appliquant une technique de fabrication en continue, technique qui est connue, actuelle et facilement reproductible.

L'invention permet un gain de poids et d'encombrement par rapport aux techniques connues sans pour autant perdre en efficacité. Elle permet une fabrication moins coûteuse, plus rapide qu'avec les techniques connues. Cette nouvelle technique est versatile et directement intégrable dans une chaîne de montage. Elle est applicable à tous les composants sous forme de puces nues ou de chips.

Dans le domaine spatial, on peut avec la méthode de l'invention obtenir un gain de poids sur les équipements électroniques embarqués supérieur à 50% par rapport aux mêmes équipements mais protégés selon des techniques classiques.

L'invention offre plusieurs variantes de réalisation, par exemple dans la manière d'obtenir l'écoulement des charges électrostatiques, dans le choix du type de matériau de blindage, dans la forme sous laquelle se présente ce matériau de blindage (lamelles, encre ou mélange chargé).

Les composants électroniques utilisés dans les équipements plongés dans un environnement radiatif ne peuvent pas supporter des doses de radiations cumulées sans modification de leurs caractéristiques. Certains sont beaucoup plus sensibles que d'autres et doivent être absolument protégés. D'autres sont beaucoup moins sensibles et il n'est pas toujours nécessaire de les protéger. Par exemple dans le cas des équipements électroniques de véhicules spatiaux, on demande que les composants électroniques puissent fonctionner pendant une durée déterminée. Il est donc impératif de protéger ceux qui sont susceptibles d'être affectés par les radiations cumulées pendant cette durée, et il n'est pas nécessaire de protéger ceux qui ne le seront pas.

Il est donc nécessaire que la protection localisée apportée à un composant lui permette de n'atteindre la dose cumulée limite pour un fonctionnement correct qu'au bout de la durée prévue.

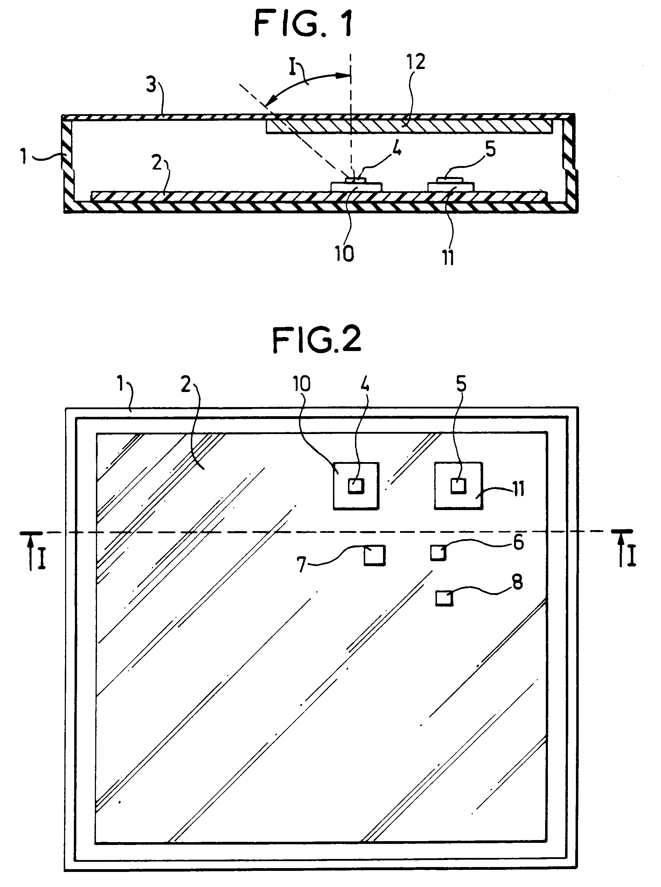

L'équipement électronique représenté aux figures 1 (coupe I-I de la figure 2) et 2 (avec couvercle enlevé) comprend un boîtier 1 en kovar par exemple sur le fond duquel a été collé un substrat 2 en alumine. Le boîtier est fermé par un couvercle 3 également en kovar. Le substrat 2 supporte un certain nombre de composants électroniques ainsi que les connexions nécessaires à son fonctionnement. On n'a représenté simplement que quelques composants, ce qui suffit à la compréhension de l'invention.

Les références 4 et 5 désignent des composants (par exemples des puces) sensibles et les références 6, 7 et 8 désignent des composants (par exemple également des puces) non sensibles aux radiations, du moins pour la durée de fonctionnement désirée.

Des éléments de protection ou de blindage sont prévus pour protéger les composants sensibles 4 et 5. Ils comprennent des éléments 10 et 11 disposés respectivement sous les composants 4 et 5, et un élément 12 situé au-dessus de ces composants et commun à ceux-ci du fait de leur proximité.

Les éléments 10 et 11 sont collés sur le substrat 2 et les composants 4 et 5 sont fixés également par collage sur ces éléments. L'élément 12 est quant à lui collé sur la face interne du couvercle 3.

La superficie des éléments de protection peut avantageusement être définie à partir d'un angle critique d'incidence pour les radiations. Cet angle critique est par exemple déterminé à partir de la normale à la surface la plus sensible ou la plus exposée des composants. L'angle critique est alors celui au-delà duquel les radiations ne sont plus gênantes pour le composant sensible, étant donné la durée de vie prévue pour l'équipement électronique et la dose cumulée acceptable pour cette durée.

Ainsi, les éléments de protection 10 et 11 peuvent avoir une superficie réduite puisque les composants sensibles 4 et 5 leur sont adjacents. Par contre, l'élément localisé 12 qui ne leur est pas adjacent a une superficie plus étendue.

Pour le composant 4, on a représenté sur la figure 1 l'angle critique d'incidence I de ce composant.

Les éléments de blindage 10, 11 et 12 peuvent être réalisés en un matériau lourd tel que le plomb, l'or, le platine, le tantale, les aciers, etc....

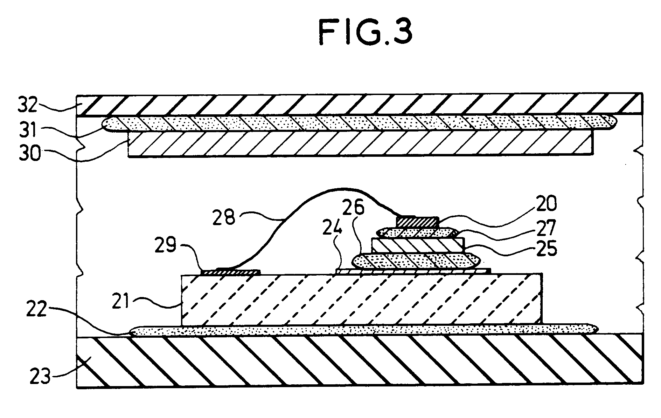

La figure 3 illustre le principe de protection localisée d'une puce nue montée en technologie hybride. Cette puce 20 est montée sur un substrat 21 (en céramique par exemple) fixé par une couche de colle isolante 22 sur le fond du boîtier 23. Le boîtier peut avoir une épaisseur de lmm et être réalisé en kovar. La puce peut être montée de la manière suivante. Une plage de report 24 en or est déposée sur le substrat 21 pour assurer la liaison électrique avec la puce. Un élément de protection inférieur 25 est fixé sur la plage de report 24 par un point de colle conductrice 26. La puce 20 est ensuite collée sur l'élément de protection 25 par un point de colle conductrice 27. Une liaison électrique entre un premier contact de la puce et la plage de report 24 est donc assurée par l'intermédiaire des points de colle conductrice et de l'élément de protection métallique 25. Un fil de connexion 28 reliant un second contact de la puce à une connexion 29 déposée sur le substrat 21 assure une autre liaison électrique avec la puce. L'élément de protection inférieure 25 peut être en tantale et avoir 0,16mm d'épaisseur.

L'élément de protection supérieure 30, constitué par une lamelle de tantale de 0,64mm d'épaisseur, est fixé par exemple par une couche de colle conductrice 31 sur la face interne du couvercle 32 du boîtier 23. Cette lamelle peut aussi être fixée au couvercle par une soudure à l'arc. Le couvercle du boîtier réalisé en kovar peut avoir 0,3mm d'épaisseur. La colle conductrice assure l'écoulement des charges électrostatiques.

La protection nécessaire pour chacun des composants sensibles est déterminée en fonction de calculs de doses cumulées de radiations fournies pour un projet donné et des doses limites relatives aux composants. La protection est exprimée en mm d'épaisseur d'aluminium. On traduit cette épaisseur d'aluminium en épaisseur du matériau lourd choisi après avoir tenu compte des épaisseurs de protection de l'environnement mécanique général. Cette épaisseur convertie représente celle de la couche du matériau lourd qui doit être, par la suite, déposée ou collée au niveau du composant sensible. La surface de la couche protectrice est déterminée en fonction de l'angle de vue minimum tolérable pour les rayonnements incidents latéraux.

Le collage du composant sensible sur une lamelle de matériau de blindage se fait en une seule fois et ne pénalise pas le temps de fabrication. Les épaisseurs de colle sont maîtrisées par un dépôt calibré réalisé au dispenseur de colle.

Un écran de sérigraphie permet de déposer, sur la face interne du couvercle, une épaisseur contrôlée de colle et localise parfaitement l'emplacement de collage. Quatre morceaux de fil d'argent de 0,1mm d'épaisseur peuvent être déposés dans le joint de colle pour donner une épaisseur de colle uniforme.

Parmi les avantages de l'invention, on peut mentionner : la réduction du volume de matière et donc du poids, une technologie à haut degré d'intégration, une réalisation en continue dans la chaîne de fabrication, un coût moins élevé par rapport aux autres méthodes, l'utilisation du boîtier hybride comme barrière primaire réduisant les effets secondaires de bremsstrahlung.

L'invention s'applique à toute protection de composants sensibles à l'environnement radiatif, au domaine militaire et en particulier au domaine spatial grâce à la réduction de poids qu'elle permet.

## Revendications

1. Méthode de protection de composants électroniques (4, 5, 20) d'un circuit contre les radiations, la protection étant obtenue par l'utilisation d'un matériau de blindage, caractérisée en ce qu'elle consiste à répartir le matériau de blindage en éléments (10, 11, 12, 25, 30) de manière à assurer une protection localisée des composants, la superficie desdits éléments étant telle qu'ils assurent la protection des composants pour un angle critique d'incidence des radiations estimé pour chaque composant.

2. Dispositif de protection des composants électroniques (4, 5, 20) d'un circuit, le dispositif comportant un matériau de blindage destiné à la protection de ces composants, caractérisé en ce que le matériau de blindage est réparti en éléments (10, 11, 12, 25, 30) assurant une protection localisée des composants.

3. Dispositif de protection selon la revendication 2, caractérisé en ce que chaque composant à protéger est fixé sur un élément de blindage.

4. Dispositif de protection selon l'une des revendications 2 ou 3, caractérisé en ce que le circuit est disposé dans un boîtier (1, 23) fermé par un couvercle (3, 32), le couvercle supportant au moins un élément de blindage (12, 30).

5. Dispositif de protection selon l'une quelconque des revendications 2 à 4, caractérisé en ce que les éléments de blindage (25, 30) sont reliés électriquement à des moyens conducteurs de l'électricité (24, 32) permettant l'évacuation des charges électrostatiques.

6.  Dispositif de protection selon la revendication 5, caractérisé en ce que la liaison électrique des éléments de blindage (25, 30) est effectuée grâce à de la colle conductrice (26, 31) ou grâce à une soudure.

# FIG. 1

# FIG.2

# FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4 642 735 (HODSDON) <br> * le document en entier * <br> --- | 1 | H05K9/00 |
| A | US-A-4 951 014 (WOHLERT ET AL.) <br> * le document en entier * <br> --- | 1 | |
| A | DE-C-3 504 726 (ROHDE & SCHWARZ) <br> * le document en entier * <br> --- | 1 | |
| A | GB-A-2 027 278 (BURR-BROWN RESEACH) <br> * le document en entier * <br> --- | 1,5 | |
| P,X | EP-A-0 407 957 (MALAURIE) <br> * le document en entier * <br><br> ----- | 1,2,4 | |

**DOMAINES TECHNIQUES RECHERCHES (Int. Cl.5)**

H05K

Le présent rapport a été établi pour toutes les revendications

| Lieu de la recherche | Date d'achèvement de la recherche | Examinateur |
|---|---|---|
| LA HAYE | 10 JANVIER 1992 | TOUSSAINT |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

          

& : membre de la même famille, document correspondant

EPO FORM 1503 03.82 (P0402)